# FASCICULE DE BREVET EUROPEEN

(11) **EP 0 859 412 B1**
(45) Date de publication et mention de la délivrance du brevet: **23.12.2009**
(21) Numéro de dépôt: 98400253.5
(22) Date de dépôt: 05.02.1998
(51) Int. Cl.: H01L 27/146

(54) **Détecteur de rayonnement photonique multicolore**
Mehrfarbiger Strahlungsdetektor
Multicolour radiation detector

(30) Priorité: 07.02.1997 FR 9701439
(43) Date de publication de la demande: 19.08.1998
(73) Titulaire: COMMISSARIAT A L'ENERGIE ATOMIQUE, 75015 Paris (FR)
(72) Inventeur: Wolny, Michel, 38000 Grenoble (FR); Destefanis, Gérard, 38120 Saint-Egreve (FR)
(74) Mandataire: Poulin, Gérard

(56) Documents cités:
- EP-A- 0 654 826
- DE-A- 3 533 146
- US-A- 4 206 470
- US-A- 5 300 777
- US-A- 5 373 182
- REINE M B ET AL: "INDEPENDENTLY ACCESSED BACK-TO-BACK HGCDTE PHOTODIODES: A NEW DUAL-BAND INFRARED DETECTOR" JOURNAL OF ELECTRONIC MATERIALS, vol. 24, no. 5, 1995, pages 669-679, XP000646681

## Description

### DOMAINE TECHNIQUE

La présente invention concerne un détecteur de rayonnement photonique multicolore.

Elle s'applique notamment :
- à la détection de rayonnements infrarouges dans la gamme de longueurs d'onde allant de 2 µm à 30 µm,
- à la détection de rayonnements dans plusieurs bandes spectrales, en particulier dans les fenêtres de transmission atmosphérique qui vont de 3 µm à 5 µm et de 8 µm à 12 µm, et
- à l'imagerie thermique.

L'invention s'applique plus particulièrement à la fabrication de caméras d'imagerie thermique et d'autodirecteurs de missiles.

### ÉTAT DE LA TECHNIQUE ANTÉRIEURE

Les détecteurs infrarouges qui ont de hautes performances et sont actuellement les plus employés sont fondés sur une technique d'hybridation d'une puce de détection sur une puce de lecture par l'intermédiaire d'un réseau de microbilles (par exemple à base d'indium) assurant l'interconnexion électrique et mécanique des deux puces.

La puce de lecture, qui permet de lire les signaux détectés par chaque pixel de la puce de détection et de les multiplexer sur une seule ou un petit nombre de sorties, est un circuit analogique à base de silicium.

La complexité de cette puce (taille, densité, caractère analogique) empêche en effet d'envisager raisonnablement toute autre technologie pour la réaliser.

La puce de détection est généralement constituée d'un grand nombre de pixels arrangés selon une structure bidimensionnelle à ixj pixels (par exemple 128x128, 256x256 ou 640x480 pixels) ou éventuellement selon une structure unidimensionnelle ou quasi-unidimensionnelle à ixj pixels, i étant égal à 1 ou très inférieur à j (par exemple 4x288 ou 4x480 pixels).

Pour réaliser cette puce de détection, plusieurs technologies sont envisageables.

Elles se distinguent par les matériaux et/ou par les dispositifs et les procédés qui sont employés pour leur fabrication.

A titre d'exemple et de manière non exhaustive, on peut citer les technologies employant des alliages CdₓHg₁₋ₓTe(0≤x≤1) épitaxiés par une quelconque technique (EPL, EJM, MOVPE, ISOVPE, etc.) sur un substrat de Cd_{1-z}Zn_{z}Te (0≤z≤1) dont le paramètre de maille est adapté ou sur un autre substrat (Si, GaAs, Al₂O₃, Ge, etc.).

Ces technologies fournissent actuellement les composants présentant les meilleures performances, et ce sur une large gamme spectrale (typiquement 2 µm à 18 µm, voire plus).

Plusieurs variantes technologiques existent pour fabriquer les composants de détection sur ces structures (planar, mésa, etc.).

On peut également citer :
- les technologies à base d'antimoniures : InSb, superréseaux GaInSb/InAs, InSb/InAsSb, etc.,
- les technologies basées sur l'absorption inter sous-bandes dans des puits quantiques (multi-puits quantiques GaAs/GaAlAs et leurs variantes),
- les technologies à base de siliciures (PtSi, IrSi, etc.) ou d'alliages Si₁₋ₓGeₓ, et
- les technologies à base de sels de plomb (PbS, PbSSe, PbSnTe, etc.).

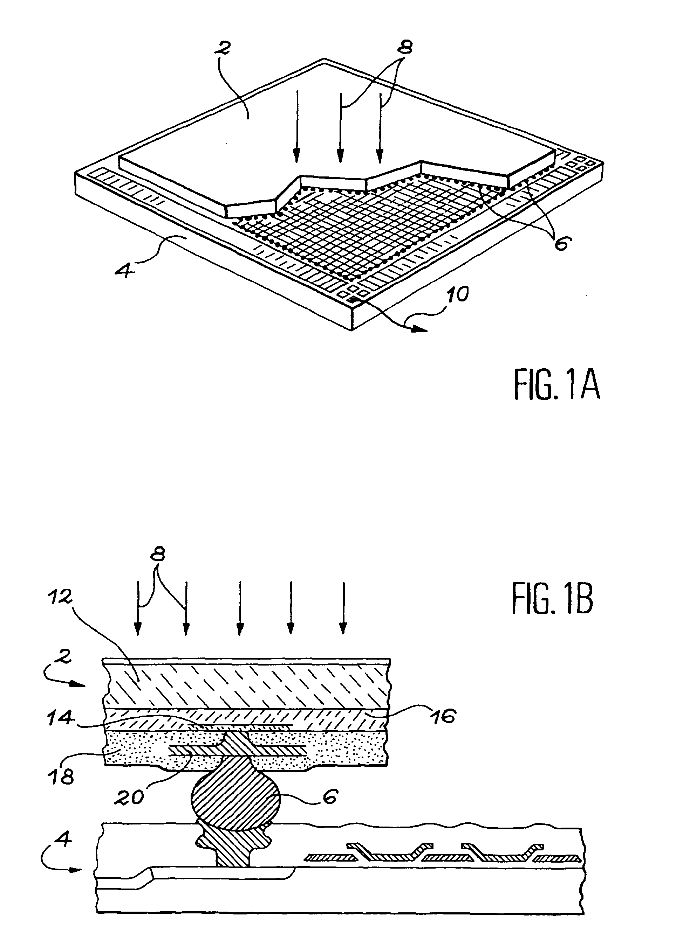

La figure 1A est une vue schématique d'un exemple de détecteur de rayonnement infrarouge bidimensionnel comprenant un circuit de détection 2 hybridé sur un circuit de lecture en silicium 4 par l'intermédiaire d'interconnexions métalliques 6.

Lorsque le circuit de détection 2 reçoit un rayonnement infrarouge 8, le circuit de lecture 4 fournit un signal vidéo 10.

La figure 1B est une vue en coupe schématique d'un pixel de détection ou élément de détection du circuit de détection 2.

Sur cette figure 1B,
- la référence 2 représente le circuit de détection,
- la référence 4 représente le circuit de lecture en silicium et
- la référence 6 représente une interconnexion métallique (bille d'indium).

Dans le circuit de détection, on voit au niveau de l'élément de détection :
- un substrat 12 en CdZnTe,
- une zone 14 en CdHgTe de type N d'une jonction PN,
- une zone 16 en CdHgTe de type P de cette jonction PN,
- une couche de passivation 18 et
- un contact 20.

Récemment est apparue une forte demande pour des composants aptes à détecter un signal infrarouge à au moins deux longueurs d'ondes différentes, comme par exemple 5 µm et 10 µm.

Des exemples d'application de tels composants se situent dans les domaines des autodirecteurs de missiles, de la détermination de signatures spectrales et de l'identification de cibles.

Plusieurs solutions technologiques pour réaliser de tels détecteurs ont déjà été proposées.

Dans la plupart des cas, elles consistent à réaliser un seul circuit de détection connecté à un circuit de lecture, le circuit de détection étant fabriqué à partir d'un empilement de matériaux aptes à détecter les longueurs d'ondes souhaitées, par exemple deux longueurs d'onde λ1 et λ2.

A ce sujet on se reportera aux documents 1 à 5 qui, comme les autres documents cités par la suite, sont mentionnés à la fin de la présente description.

Ces solutions requièrent des structures épitaxiales délicates à réaliser.

De plus, elles n'autorisent pas, de façon simple, une grande souplesse dans le choix des matériaux utilisables pour détecter chaque longueur d'onde : ceux-ci doivent préférentiellement appartenir à une même famille (par exemple alliages CdHgTe de compositions différentes) sous peine de se trouver face à d'importantes difficultés technologiques pour faire croître les structures.

En outre, un seul circuit de lecture étant ici utilisé pour lire les deux signaux correspondant aux deux longueurs d'ondes que l'on veut détecter, sa conception est délicate en particulier si l'on veut assurer la cohérence spatio-temporelle des informations relatives à chaque longueur d'onde.

De plus un risque non négligeable d'intermodulation des signaux correspondant à chacune des deux longueurs d'onde que l'on veut détecter (par exemple présence d'un signal de longueur d'onde λ1 dans la diode destinée à lire le signal de longueur d'onde λ2) existe généralement dans de telles structures.

Enfin ces dernières imposent généralement une définition des zones actives des pixels par gravure d'une structure mesa, ce qui rend le procédé de fabrication plus délicat.

Il est à souligner que, dans le cas des documents 4 et 5, on met en jeu un mode de détection fondé sur des structures MIS (ou SIS) sur CdHgTe, structures qui sont difficiles à maîtriser.

D'autres solutions sont proposées dans les documents 6, 7 et 8.

Celles-ci présentent les inconvénients indiqués ci-après.

A partir de la solution mentionnée dans le document 6, on ne peut envisager que des détecteurs monoéléments ou à très petit nombre de pixels.

Avec la solution mentionnée dans le document 7, seule une architecture en barrette linéaire est possible.

Tout au mieux peut-on concevoir un composant à ixj pixels avec j inférieur à 5 (typiquement).

La solution mentionnée dans le document 8 propose la combinaison d'un détecteur dans le domaine visible et d'un détecteur dans le domaine infrarouge qui est éventuellement bicolore.

Il est bien spécifié que, avec cette solution, le détecteur placé sur le premier substrat utilisé est un détecteur dans le domaine visible.

De plus, la cohérence spatiale des informations correspondant aux deux longueurs d'onde détectées ne semble pas assurée lorsque l'on observe les figures de ce document 8.

US 4206470 décrit une interconnexion à couches minces pour détecteur CCD multicolore infrarouge. EP 0654826 décrit un détecteur de rayonnements dans deux bandes de longueurs d'ondes et un procédé de fabrication de ce détecteur.

### EXPOSE DE L'INVENTION

La présente invention résout le problème de la conception d'un détecteur :
- qui soit apte à détecter au moins deux rayonnements ayant des longueurs d'onde distinctes et par exemple situés dans le domaine infrarouge,
- qui puisse être de grande complexité c'est-à-dire comporter un grand nombre de pixels,
- qui puisse avoir une topologie bidimensionnelle,
- qui conduise à une très bonne séparation spectrale des deux rayonnements que l'on veut détecter,
- qui assure la cohérence spatio-temporelle des informations correspondant aux deux longueurs d'onde issues de chaque pixel et
- qui puisse être réalisé avec un pas de pixel à pixel suffisamment petit pour ne pas être trop onéreux lorsque sa taille est grande et correspond par exemple à une mosaïque de 256x256 pixels.

Le détecteur objet de l'invention est réalisable de façon simple et à partir de technologies existantes et utilisées industriellement.

On indique ci-après le principe d'un détecteur bicolore conforme à l'invention mais il est bien entendu que la présente invention concerne aussi des détecteurs aptes à détecter plus de deux longueurs d'onde et que le principe exposé ci-après est extensible à de tels composants.

Dans ce qui suit, on considère un détecteur bicolore qui est apte à détecter deux longueurs d'onde λs et λi, λs étant supérieure à λi.

Conformément à la présente invention, on superpose deux composants distincts, à savoir un premier composant apte à détecter un rayonnement de longueur d'onde λi et un deuxième composant apte à détecter un rayonnement de longueur d'onde λs, le composant apte à détecter le rayonnement de longueur λi étant placé en premier face aux rayonnements incidents à détecter et étant transparent à la longueur d'onde λs sur une portion importante de sa zone active dans laquelle est détectée le rayonnement de longueur d'onde λi.

Chacun de ces premier et deuxième composants a une architecture bidimensionnelle mais peut aussi avoir une architecture unidimensionnelle.

Chacun de ces premier et deuxième composants inclut un circuit de lecture qui est de préférence à base de silicium.

Le circuit de détection de chacun des premier et deuxième composants peut être soit hybridé à son circuit de lecture, par exemple par un réseau de microbilles d'indium, soit intégré monolithiquement sur le circuit de lecture.

Les premier et deuxième composants superposés ont de préférence le même nombre de pixels, ces pixels formant une matrice à N lignes et M colonnes, et la même topologie (en ce qui concerne l'arrangement des pixels et le pas entre pixels) et sont disposés de sorte que les pixels des premier et deuxième composants ayant le même numéro de ligne i et le même numéro de colonne j soient placés l'un au-dessus de l'autre.

La transparence du premier composant, qui est apte à détecter un rayonnement de longueur d'onde λi est obtenu par l'intermédiaire de la transparence de son circuit de détection et de son circuit de lecture.

La transparence du circuit de détection est obtenue « naturellement » (le circuit de détection détectant jusqu'à λi et laissant passer les longueurs d'onde supérieures) et celle du circuit de lecture est assurée par une conception appropriée qui laisse transparente une zone importante de chaque pixel.

Le circuit de lecture est par exemple réalisé sur un substrat de silicium très faiblement dopé et possédant un très faible taux d'oxygène.

Si ce n'est pas le cas, le substrat de silicium peut par exemple être aminci.

On peut également utiliser un substrat SOI pour fabriquer le circuit de lecture, la partie non active du substrat étant ensuite enlevée.

De façon précise, la présente invention concerne un détecteur de rayonnement multicolore, ce détecteur étant apte à détecter au moins deux rayonnements incidents ayant respectivement deux longueurs d'onde distinctes λi1 et λs1, avec λs1>λi1, ce détecteur comprenant:
- un premier composant apte à détecter au moins le rayonnement de longueur d'onde λi1, et
- un deuxième composant apte à détecter au moins le rayonnement de longueur d'onde λs1,
le premier composant étant placé face aux rayonnements incidents de manière que ce premier composant reçoive le rayonnement de longueur d'onde λi1 avant que le deuxième composant ne reçoive le rayonnement de longueur d'onde λs1, le premier composant étant transparent au moins au rayonnement de longueur d'onde λs1 dans une partie importante de la zone active de ce premier composant, zone dans laquelle est détecté le rayonnement de longueur d'onde λi1, ce détecteur étant **caractérisé en ce que** le premier composant comprend un circuit de détection et un circuit de lecture qui forment respectivement une matrice de pixels de détection et une matrice de pixels de lecture à h1 lignes et m1 colonnes, le deuxième composant comprenant un circuit de détection et un circuit de lecture qui forment respectivement une matrice de pixels de détection et une matrice de pixels de lecture à n2 lignes et m2 colonnes, n1, m1, n2 et m2 étant des nombres entiers supérieurs ou égaux à 1, les pixels de détection et de lecture d'au moins une partie de l'un des premier et deuxième composants étant respectivement placés en regard des pixels de détection et de lecture de l'autre de ces premier et deuxième composants.

Le premier composant peut être apte à détecter en outre un autre rayonnement de longueur d'onde λi2 inférieure à la longueur d'onde de chaque rayonnement que le deuxième composant est apte à détecter.

Le deuxième composant peut être apte à détecter en outre un autre rayonnement de longueur d'onde λs2 supérieure à la longueur d'onde de chaque rayonnement que le premier composant est apte à détecter.

Selon un premier mode de réalisation particulier du détecteur objet de l'invention le circuit de détection de l'un au moins des premier et deuxième composants est hybridé au circuit de lecture de celui-ci.

Les circuits peuvent être hybridés l'un à l'autre au moyen de microbilles électriquement conductrices.

Selon un deuxième mode de réalisation particulier, le circuit de détection de l'un au moins des premier et deuxième composants est intégré monolithiquement au circuit de lecture de celui-ci.

Les premier et deuxième composants peuvent avoir le même nombre de pixels, n1 étant égal à n2 et m1 égal à m2.

Ils peuvent aussi avoir la même topologie c'est-à-dire le même arrangement de pixels et le même pas entre pixels.

Le détecteur objet de l'invention peut comprendre en outre des couches anti-reflets aptes à empêcher des réflexions de rayonnements sur des faces de ce détecteur de manière à éviter des pertes de rayonnements.

Il peut comprendre en outre des moyens de filtrage ou d'absorption des rayonnements de longueurs d'onde inférieures ou égales à chaque longueur d'onde que le second composant est apte à détecter.

Chaque circuit de lecture peut être à base de silicium.

Chaque rayonnement peut être un rayonnement infrarouge.

### BRÈVE DESCRIPTION DES DESSINS

La présente invention sera mieux comprise à la lecture de la description d'exemples de réalisation donnés ci-après, à titre purement indicatif et nullement limitatif, en faisant référence aux dessins annexés sur lesquels :
- la figure 1A, déjà décrite, est une vue en perspective schématique d'un détecteur connu de rayonnement,
- la figure 1B, déjà décrite, est une vue en coupe schématique d'un pixel du circuit de détection du détecteur de la figure 1A,
- les figures 2A à 2F sont des vues en coupe transversale schématique de détecteurs conformes à l'invention,
- les figures 2G et 2H sont des vues en coupe transversale schématique d'autres détecteurs conformes à l'invention,
- la figure 3 est une vue schématique d'un pixel du circuit de lecture d'un détecteur conforme à l'invention,
- la figure 4A est une vue en coupe transversale schématique d'un pixel de détection hybridé, dans un détecteur conforme à l'invention, et
- la figure 4B est une vue de dessus schématique du pixel de détection de la figure 4A.

### EXPOSÉ DÉTAILLÉ DE MODES DE RÉALISATION PARTICULIERS

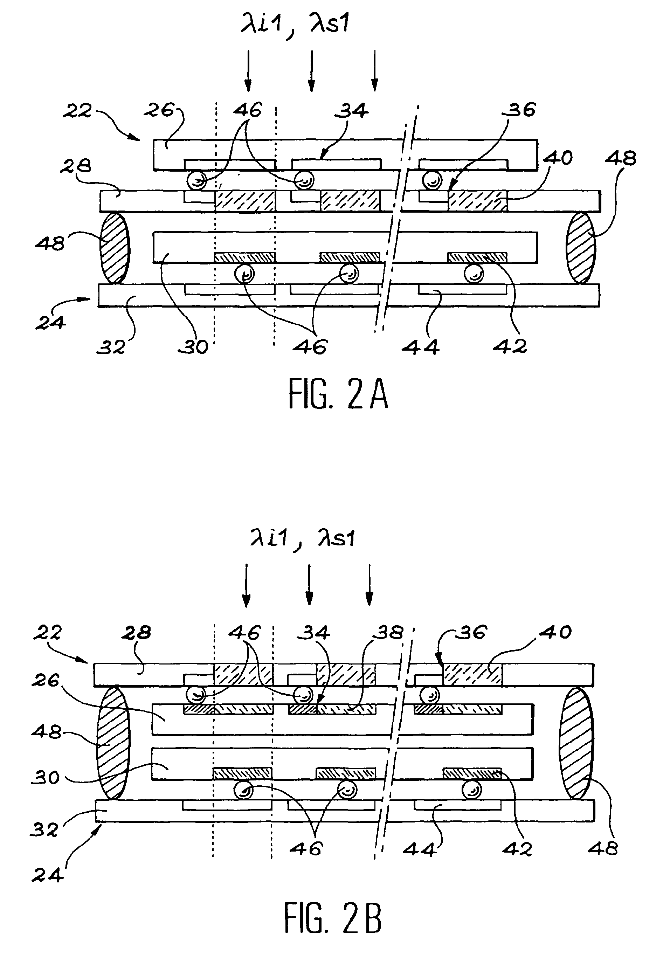

Le détecteur de rayonnement multicolore conforme à l'invention, qui est représenté schématiquement en coupe transversale sur la figure 2A, est destiné à détecter deux rayonnements infrarouges incidents ayant respectivement deux longueurs d'onde distinctes λi1 et λs1, avec λs1>λi1.

Il s'agit par exemple de rayonnements infrarouges.

Le détecteur de la figure 2A comprend :
- un premier composant 22 apte à détecter le rayonnement de longueur d'onde λi1, et
- un deuxième composant 24 apte à détecter le rayonnement de longueur d'onde λs1.

Le premier composant 22 est placé face au rayonnement multicolore incident de manière que ce premier composant reçoive le rayonnement de longueur d'onde λi1 avant que le deuxième composant 24 ne reçoive le rayonnement de longueur d'onde λs1 qu'il doit détecter.

Le premier composant 22 est transparent au rayonnement de longueur d'onde λs1 dans une partie importante de la zone active de ce composant 22, zone dans laquelle on détecte le rayonnement de longueur d'onde λi1.

De plus, le premier composant 22 comprend un circuit de détection 26 et un circuit de lecture 28 et le deuxième composant 24 comprend également un circuit de détection 30 et un circuit de lecture 32.

Le circuit 26 comprend une matrice de pixels de détection à λi1, référencés 34, et le circuit 28 comprend une matrice de pixels de lecture à λi1, référencés 36.

La matrice des pixels 34 et la matrice des pixels 36 ont le même nombre de lignes et le même nombre de colonnes, chaque pixel 34 étant disposé au-dessus de l'un des pixels 36.

Sur la figure 2A, on voit simplement une ligne de chacune des matrices du détecteur.

Dans le cas de la figure 2A, toute la surface de chaque pixel 34 peut être optiquement active.

La référence 40 représente la partie transparente à λs1 de chaque pixel 36.

Le circuit de détection 30 comprend une matrice de pixels de détection à λs1 référencés 42.

Le circuit de lecture 32 comprend également une matrice de pixels de lecture à λs1 référencée 44.

Les matrices de pixels 42 et 44 ont le même nombre de lignes et le même nombre de colonnes, chaque pixel 42 étant situé au-dessus de l'un des pixels 44.

Les circuits 26 et 28 sont hybridés l'un à l'autre et il en est de même pour les circuits 30 et 32.

Dans l'exemple représenté, les hybridations sont réalisées au moyen de micro-billes conductrices 46 par exemple en indium.

De plus, chaque ensemble de pixels superposés 34 et 36 se trouve au-dessus d'un ensemble de pixels superposés 42 et 44.

En effet, dans l'exemple de la figure 2A, toute les matrices ont le même nombre de lignes et le même nombre de colonnes.

De plus, dans les composants 22 et 24, les pixels sont arrangés de la même façon et le pas entre pixel est le même.

Cependant, dans d'autres modes de réalisation particuliers non représentés, les matrices de pixels 34 et 36 (qui ont le même nombre de lignes et le même nombre de colonnes) n'ont pas un nombre de lignes et un nombre colonnes identiques à ceux des matrices de pixels 42 et 44.

Par exemple, les matrices de pixels 42 et 44 pourraient avoir plus de lignes et/ou plus de colonnes que les matrices de pixels 34 et 36.

De la même manière, dans l'exemple de la figure 2A, l'arrangement des pixels et le pas entre les pixels sont les mêmes dans les circuits de détection et les circuits de lecture.

Cependant, dans d'autres modes de réalisation particuliers non représentés, l'arrangement des pixels et/ou le pas entre pixels dans le composant 22 pourraient ne pas être les mêmes que dans le composant 24.

On voit également sur la figure 2A des éléments de connexion 48 permettant de fixer mécaniquement le composant 22 au composant 24 et d'éventuellement associer une connexion électrique entre ces composants.

Dans l'exemple représenté, ces éléments de connexion 48 sont par exemple en indium ou en indium-étain et relient le circuit 28 au circuit 32.

Dans le cas de la figure 2A, le circuit de détection 26 est éclairé par les rayonnements infrarouges par sa face-arrière qui est la face opposée à celle sur laquelle sont formés les pixels 34.

De même, le circuit de détection 30 est éclairé par le rayonnement de longueur d'onde λs1 par sa face-arrière c'est-à-dire la face opposée à celle sur laquelle sont formées les pixels 42.

Le détecteur conforme à l'invention, qui est schématiquement représenté en coupe transversale sur la figure 2B, diffère du détecteur de la figure 2A par le fait que l'on a retourné le premier composant 22, les éléments de connexion 48 permettant toujours la fixation du circuit 32 au circuit 28, et que les parties référencées 40 sont à présent non seulement transparentes à la longueur d'onde λs1 mais encore transparentes à la longueur d'onde λi1.

Dans le cas de la figure 2B, le composant 22 est encore composé du circuit de détection 26 et du circuit de lecture 28 mais il est éclairé par la face-avant du circuit 26 c'est-à-dire la face sur laquelle sont formés les pixels de détection à la longueur d'onde λi1.

Sur la figure 2B, la référence 38 représente la partie optiquement active de chaque pixel 34.

Le composant 24, qui détecte le rayonnement de longueur d'onde λs1, est encore composé du circuit de détection 30 et du circuit de lecture 32 et il est toujours éclairé par la face-arrière du circuit 30.

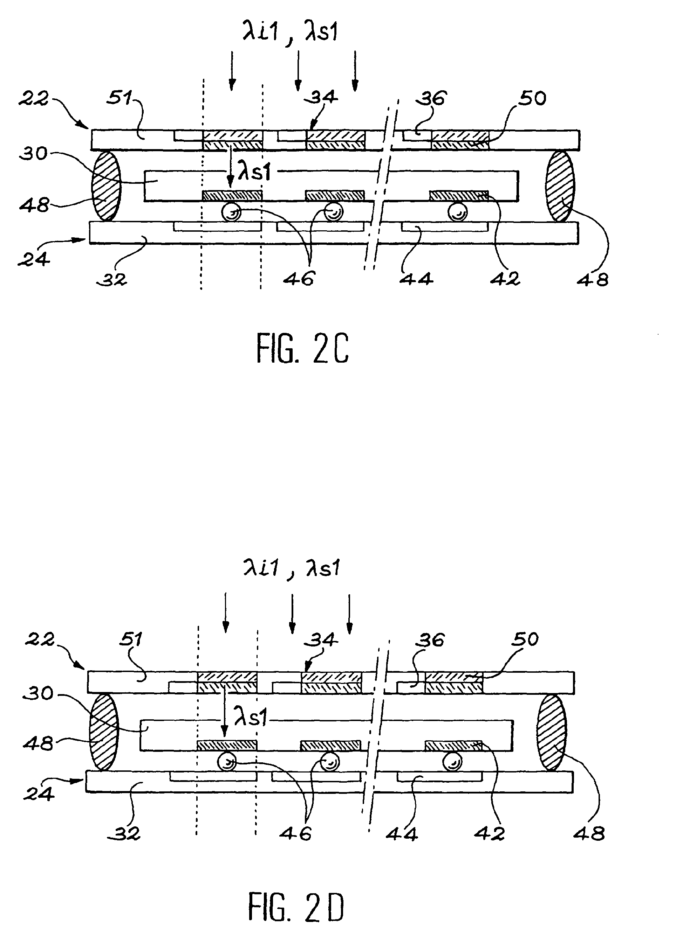

Le détecteur conforme à l'invention, qui est schématiquement représenté en coupe transversale sur la figure 2C, comprend encore le composant 24 de la figure 2A.

Cependant, le composant 22 comprend, dans le cas de la figure 2C, un circuit de détection qui est intégré monolithiquement à un circuit de lecture et éclairé par sa face-avant.

Le composant 24 est encore éclairé par sa face-arrière.

On voit sur la figure 2C la matrice de pixels de détection 34 qui comprennent une partie 50 transparente à la longueur d'onde λs1.

On voit également la matrice de pixels de lecture 36 formés dans le même substrat 51 que les pixels de détection 34.

Dans le cas de la figure 2C, les éléments de connexion 48 relient mécaniquement et éventuellement électriquement ce substrat 51 au circuit de lecture à la longueur d'onde λs1.

Le détecteur conforme à l'invention, qui est schématiquement représenté en coupe transversale sur la figure 2D, comprend encore le deuxième composant 24 utilisé dans le détecteur de la figure 2C mais le premier composant 22 de cette figure 2C a été retourné dans le cas de la figure 2D.

Dans ces conditions, le composant 22, qui détecte à la longueur d'onde λi1, a son circuit de détection qui est intégré monolithiquement à son circuit de lecture et qui est éclairé par sa face-arrière c'est-à-dire la face du substrat opposée à celle où sont formés les pixels de détection à la longueur d'onde λi1.

Le circuit de détection à la longueur d'onde λs1 est encore éclairé par sa face-arrière.

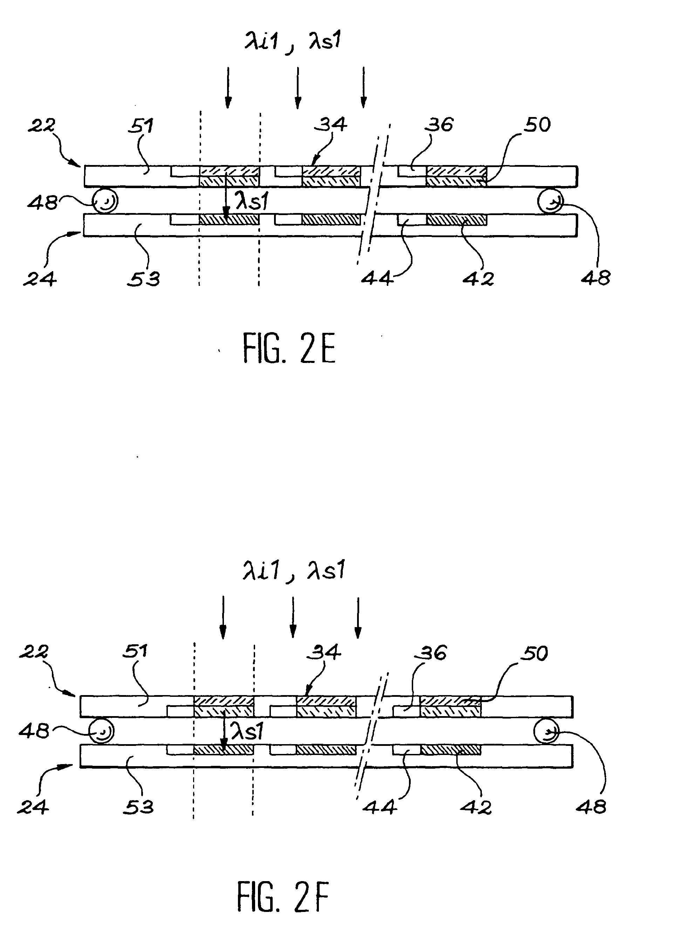

Le détecteur conforme à l'invention, qui est schématiquement représenté en coupe transversale sur la figure 2E, comprend encore le composant 22 de la figure 2C dont le circuit de détection à la longueur d'onde λi1 est éclairé par sa face-avant.

Dans le cas de la figure 2E, le deuxième composant 24 comprend un circuit de détection à la longueur d'onde λs1, qui est associé à un circuit de lecture et intégré monolithiquement à celui-ci.

On voit sur la figure 2E la matrice de pixels de détection à la longueur d'onde λs1, référencés 42, ainsi que la matrice de pixels de lecture à la longueur d'onde λs1, référencés 44.

Ces matrices sont formées sur un même substrat 53, ce substrat 53 étant aussi éclairé par sa face-avant qui porte les pixels de détection et les pixels de lecture.

Dans le cas de la figure 2E, les éléments de connexion 48 permettent de fixer mécaniquement l'un par rapport à l'autre le substrat 51 où sont formés le circuit de détection et le circuit de lecture à la longueur d'onde λi1 et le substrat 53 sur lequel sont formés le circuit de détection et le circuit de lecture à la longueur d'onde λs1 et éventuellement de connecter électriquement ces deux circuits.

Le détecteur conforme à l'invention, qui est schématiquement représenté en coupe transversale sur la figure 2F, comprend encore le composant 24 de la figure 2E qui est éclairé par sa face-avant.

Ce détecteur de la figure 2F comprend aussi le composant 22 de la figure 2E mais, dans le cas de cette figure 2F, ce composant 22 a été retourné de sorte qu'il est éclairé par sa face-arrière dans le cas de la figure 2F.

On précise que dans toutes les figures 2A à 2F, les éléments de connexion latéraux 48 assurent une tenue mécanique de l'ensemble des composants 22 et 24 éventuellement leur connexion électrique.

Ils sont choisis, quant à leur forme et à leur nature, de manière à permettre un bon refroidissement du premier composant 22 qui détecte la longueur d'onde λi1.

Au vu des figures 2A à 2F, il apparaît clairement qu'un aspect essentiel des détecteurs conformes à la présente invention, qui sont représentés sur ces figures, réside dans l'utilisation, pour le composant apte à détecter à la longueur d'onde λi1, d'un circuit de lecture qui est transparent aux rayonnements incidents et notamment à la longueur d'onde λs1 dans une portion au moins de chaque pixel qui porte le pixel de détection à la longueur d'onde λi1 λi1 ou qui est en regard du pixel de détection à la longueur d'onde λi1.

Il va de soi que les configurations présentées dans les figures 2A à 2F ne sont pas les seules possibles et que tout assemblage de deux composants que l'homme du métier est capable de déduire de ces configurations rentre dans le cadre de la présente invention.

A titre d'exemple, la présente invention concerne aussi un composant à la longueur d'onde λs1 qui utilise un circuit de détection réalisé, par l'intermédiaire d'une hétéro-épitaxie, sur la face inférieure du substrat 28 ou 51 portant le composant à la longueur d'onde λi1 dans le cas des figures 2A, 2C et 2E.

De plus, pour éviter des pertes de rayonnement (notamment à la longueur d'onde λs1) liées à des réflexions sur les diverses surfaces sur le trajet des rayonnements, des traitements anti-reflets adaptés peuvent être formés sur chacune de ces surfaces.

On indique ci-après les avantages offerts par la présente invention.

Pour être mise en oeuvre, la présente invention ne requiert que des technologies existantes, ce qui est en soi un avantage technique important car cela assure des garanties de fiabilité des composants ainsi fabriqués.

Un autre avantage de la présente invention réside dans la totale liberté qu'elle laisse pour choisir, parmi tout l'éventail possible rappelé ci-dessus, le circuit de détection le mieux adapté pour chaque longueur d'onde qu'on veut détecter et pour l'application visée.

L'invention permet d'assurer, au niveau de chaque pixel, la cohérence spatio-temporelle des rayonnements correspondant à chacune des deux longueurs d'onde à détecter.

Elle permet de réaliser sans difficulté des ensembles de détection bicolore de grande complexité, comme par exemple des mosaïques bidimensionnelles de grande taille, tout en conservant une taille de dispositif faible : des pas inter-pixels très petits sont en effet possibles.

Elle permet aussi d'éviter une intermodulation des signaux correspondant aux deux longueurs d'onde que l'on veut détecter.

En effet, il suffit d'insérer entre les deux composants utilisés un dispositif filtrant ou absorbant toutes les longueurs d'onde inférieures ou égales à λi1 afin d'obtenir un rayonnement à λs1 exempt de tout résidu de rayonnement à la longueur d'onde λi1.

De plus, dans certains modes de réalisation particuliers (correspondant par exemple aux figures 2B, 2D et 2F) les plans focaux correspondant à chacune des longueurs d'onde à détecter peuvent être confondus, ce qui évite l'emploi de tout système optique supplémentaire pour assurer leur positionnement respectif vis-à-vis des détecteurs de manière optimale.

On peut aussi réaliser un détecteur tricolore ou quadricolore conforme à l'invention.

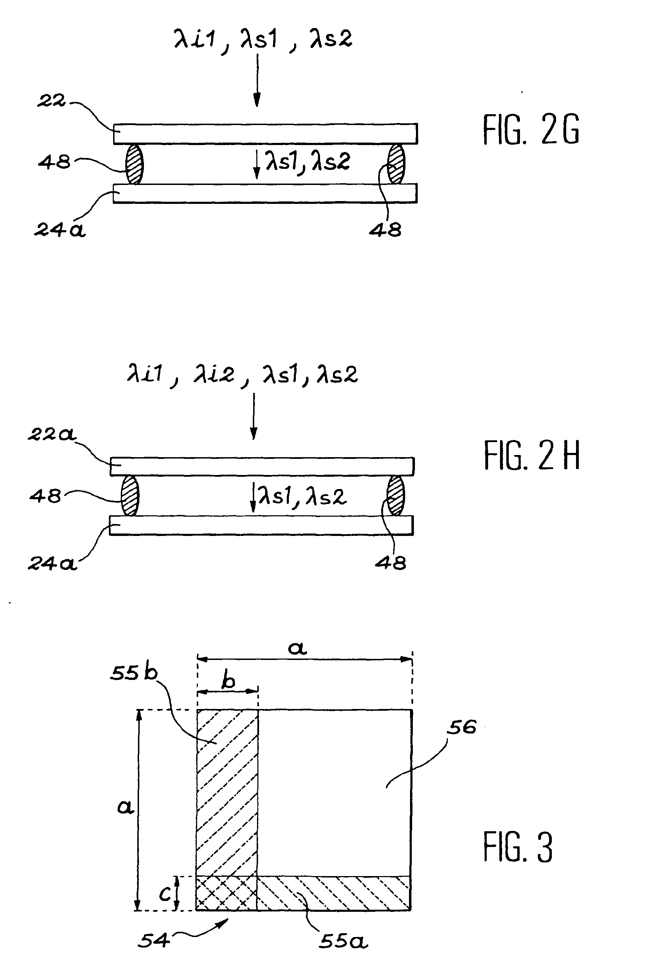

Pour obtenir un détecteur tricolore, il suffit d'utiliser, en tant que deuxième composant, un composant "bicolore" 24a (figure 2G) apte à détecter non seulement la longueur d'onde λs1 mais aussi une longueur d'onde λs2, avec λs2>λi1, ce composant 24a étant fabriqué selon une méthode quelconque comme par exemple celles qui sont indiquées dans les documents 1, 2 et 3.

Ce composant 24a est encore relié au composant 22 par les éléments 48.

Pour obtenir un détecteur quadricolore (figure 2H), il suffit d'utiliser le composant 24a et, à la place du composant 22 détectant à la longueur d'onde λi1, un composant bicolore 22a détectant à la longueur d'onde λi1 et à une longueur d'onde λi2, avec λi2<λs1 et λi2<λs2, et fabriqué selon une méthode quelconque, comme par exemple celles qui sont présentées dans les documents 1, 2 et 3.

On explique ci-après un exemple de réalisation d'un détecteur conforme à l'invention qui est fondé sur l'architecture présentée sur la figure 2B.

Ce détecteur est destiné à fonctionner à la température de 77 K ou à une température voisine de celle-ci.

Le composant 22 détectant à λi1 est une mosaïque bidimensionnelle comportant 128x128 pixels avec un pas de 50 µm (un pas plus petit serait possible, par exemple 35 µm).

Son circuit de détection 26 se compose d'un ensemble de 128x128 diodes N/P réalisées sur un alliage cdₓHg₁₋ₓTe avec x voisin de 0,30, ce qui assure une détection jusqu'à environ 5 µm.

Cet alliage est déposé en couche mince sur un substrat de cd_{0,96}Zn_{0,04}Te par épitaxie en phase liquide selon des techniques bien connues.

La matrice de diodes est fabriquée avec le procédé utilisé par exemple dans le document 9.

Ce circuit de détection est ensuite hybridé, par l'intermédiaire d'un réseau de microbilles d'indium, à un circuit de lecture CMOS sur silicium (circuit 28).

Encore une fois, le procédé d'hybridation est largement connu.

Le circuit de lecture 28 employé est réalisé sur un substrat de silicium le plus transparent possible à l'infrarouge jusqu'à au moins 10 µm : en particulier ce substrat comporte un très faible taux d'oxygène.

Il peut éventuellement être aminci.

De plus, la topologie du circuit de lecture 28 est telle que, au niveau de chaque pixel, une grande zone du substrat en silicium est laissée vierge de tout traitement technologique susceptible d'absorber le rayonnement infrarouge incident entre 3 et 10 µm.

La figure 3 présente une vue de dessus schématique d'un pixel 54 de ce circuit de lecture.

La référence 55a représente un passage d'interconnections et la référence 55b représente la zone active du pixel du circuit de lecture qui a une partie commune avec le passage d'interconnexions.

Dans l'exemple de la figure 3, cette partie commune a une taille de 8 µm x 15 µm.

Le pixel en vue de dessus forme un carré de côté a (50 µm), la zone active forme un rectangle de dimensions axb (50 µm x 15 µm) et le passage d'interconnexions forme un rectangle de dimensions axc (50 µm x 8 µm).

La surface de la zone 56, qui est transparente jusqu'à au moins 10 µm sur chaque pixel, représente environ 60% de la surface du pixel 54.

Ainsi le facteur de remplissage des deux mosaïques de détection est voisin de 60%.

Il est à noter que ce facteur de remplissage pourrait être accru par une conception de circuit de lecture optimisée vis-à-vis de ce paramètre et/ou par l'emploi de filières technologiques sur silicium avec des motifs plus petits.

De plus, le substrat en silicium portant le circuit de lecture 28 est plus grand que le circuit de détection 26 de manière à permettre la connexion des deux composants 22 et 24 détectant respectivement à 5 µm et 10 µm.

La topologie du circuit de détection 26 est telle que les diodes sont uniquement réalisées sur les surfaces en regard des zones de transparence du circuit de lecture après hybridation.

Par "diode", on entend toute la zone optiquement active et pas la simple zone où se situe la jonction.

Enfin la structure de chaque pixel de détection est telle qu'un éclairement par la face-avant, c'est-à-dire la face portant la jonction N/P, soit possible.

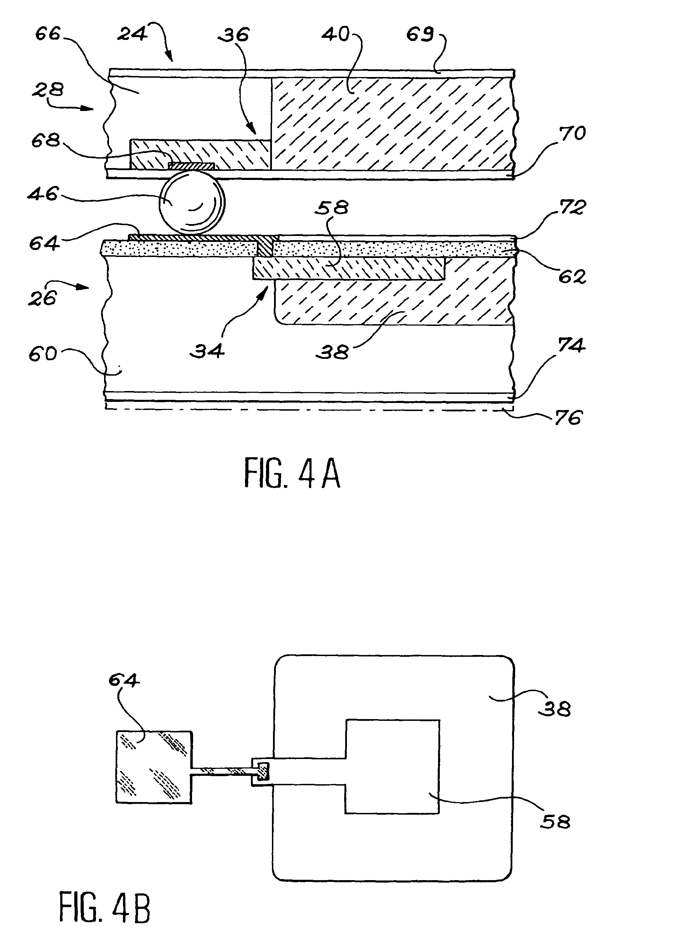

La figure 4A est une vue en coupe transversale schématique d'un pixel de détection hybridé.

Sur la figure 4A, on voit :
- la zone optiquement active 38 du pixel de détection 34,
- la zone 58 de type N de ce pixel 34,
- la couche 60 en CdHgTe de type P dans laquelle sont formés les pixels de détection,
- une couche de passivation 62 qui recouvre cette couche 60,
- un contact électrique 64 associé au pixel 34, qui est formé sur la couche 62 et qui est relié à la zone 58,
- le pixel de lecture 36 correspondant au pixel 34,
- la zone 40 transparente à 5 µm et à 10 µm, le substrat 66 en silicium dans lequel sont formés les pixels de lecture 36, et
- un contact électrique 68 associé au pixel 36 et relié au contact 64 par l'intermédiaire d'une microbille 46.

Le pixel de détection 34 est représenté de façon schématique et partielle en vue de dessus sur la figure 4B.

De plus, l'épaisseur de la couche de CdHgTe peut éventuellement être choisie suffisamment importante pour bloquer pratiquement tout le rayonnement à 5 µm et ainsi minimiser la "pollution" du signal à 10 µm par le signal à 5 µm : elle est par exemple de 20 µm.

Après hybridation du circuit de détection 26 sur le circuit de lecture 28, le substrat de Cd_{0,96}Zn_{0,04}<Te est enlevé à l'aide d'un procédé présenté dans le document 10.

Ceci permet d'accroître la tenue lors de cycles thermiques (300 K -77 K) du composant et permet aussi de réduire l'espace entre les deux circuits de détection, ce qui diminue les problèmes de focalisation optique.

Enfin des revêtements antireflets 69, 70, 72 et 74 sont respectivement disposés sur la face-arrière du circuit de lecture 28 (première interface à recevoir le rayonnement incident), la face-avant de ce circuit 28, la face-avant du circuit de détection 26 et la face-arrière de ce circuit de détection 26 (face inférieure du composant 22).

Ce dernier revêtement antireflet 74, déposé après que le substrat de CdZnTe ait été enlevé, est spécialement optimisé pour être efficace à 10 µm (les photons au voisinage de 5 µm perdus par réflexion ne feront que renforcer la « pureté spectrale » du signal à 10 µm).

Si l'on a choisi de travailler avec une épaisseur de CdHgTe qui ne permet pas un filtrage spectral suffisant, on peut ajouter à ce niveau un filtre 76 qui ne laisse passer que les longueurs d'onde supérieures à 5 µm.

Le composant 24 détectant à λs1 est une mosaïque bidimensionnelle comportant 128x128 pixels de même pas et même topologie que le composant 22 détectant à λi1.

Son circuit de détection se compose d'un ensemble de 128x128 diodes N/P réalisées sur un alliage cdₓHg₁₋ₓTe avec x voisin de 0,22, ce qui assure une détection jusqu'à environ 10 µm.

Cet alliage est déposé en couche mince (épaisseur voisine de 10 µm) sur un substrat de Cd_{0,96}Zn_{0,04}Te par épitaxie en phase liquide selon des techniques bien connues et la matrice de diodes est fabriquée avec le procédé utilisé par exemple dans la référence 9.

Les zones actives du circuit de détection du composant 24, qui est éclairé par sa face-arrière, présentent une topologie identique à celle du circuit de détection du composant détectant à 5 µm.

Ce circuit de détection est ensuite hybridé par l'intermédiaire d'un réseau de microbilles d'indium à un circuit de lecture CMOS sur silicium au moyen du même procédé que celui employé pour la fabrication du composant détectant à 5 µm.

Le substrat de CdZnTe est alors enlevé par le même procédé que celui employé pour ce composant détectant à 5 µm.

Un revêtement anti-reflet à 10 µm est ensuite déposé sur la face-arrière du circuit de détection à 10 µm.

Les deux composants détectant respectivement à 5 µm et 10 µm sont connectés par l'intermédiaire de billes d'indium de fort diamètre (typiquement 100 µm).

La précision du procédé d'hybridation permet de garantir le bon positionnement des deux composants l'un par rapport à l'autre.

De plus ces billes permettent d'assurer, par l'intermédiaire du composant détectant à 10 µm, un contact thermique correct entre le plan froid du cryostat permettant le fonctionnement du détecteur à 77 K et le composant détectant à 5 µm.

Ce contact peut éventuellement être amélioré par une conception adéquate du cryostat dans laquelle le doigt froid du cryostat serait partiellement amené sur les bords de la face-arrière du circuit de lecture du composant détectant à 5 µm.

Toutefois, il est à noter que la température de fonctionnement de l'ensemble étant voisine de 77 K pour assurer des performances optimales pour le composant à 10 µm, le composant à 5 µm n'a pas rigoureusement besoin d'une température de 77 K.

Ses performances sont en effet pratiquement inchangées jusqu'à au moins 120 K.

Les documents cités dans la présente description sont les suivants :
1. E.F. Shulte, US Patent n°5,113,076, 12 mai 1992
2. M.B. Reine et al., Journal of Electronic Materials, vol.24, n°5, 1995
3. P.R. Norton, US Patent 5,380,669, 10 janvier 1995
4. M.W. Goodwin, US Patent 5,300,777, 5 avril 1994
5. M.W. Goodwin, US Patent 5,374,841, 20 décembre 1994
6. J. Roschen, US Patent 3,962,578, 8 juin 1976
7. F. Marion, demande de brevet français n°93 13992, 23 novembre 1993
8. P.R. Norton, US Patent 5,373,182, 13 décembre 1994
9. G.L. Destefanis, « HgCdTe infrared diode arrays », Semicond. Sci. Technol., 6, 1991, p.88-92
10. J.L. Tissot, F. Marion, 2nd NATO/IRIS Joint Symposium, Londres, 25-28 juin 1996.
11. W.J. White, US Patent 4,206,470, 3 juin 1980.
12. M. Lydie, demande de brevet européen EPO 654 826 A1, 24 mai 1995.

## Revendications

1. Détecteur de rayonnement multicolore, ce détecteur étant apte à détecter au moins deux rayonnements incidents ayant respectivement deux longueurs d'onde distinctes λi1 et λs1, avec λi1>λi1, ce détecteur comprenant:
- un premier composant (22, 22a) apte à détecter au moins le rayonnement de longueur d'onde λi1, et
- un deuxième composant (24, 24a) apte à détecter au moins le rayonnement de longueur d'onde λs1,
le premier composant étant placé face aux rayonnements incidents de manière que ce premier composant reçoive le rayonnement de longueur d'onde λi1 avant que le deuxième composant ne reçoive le rayonnement de longueur d'onde λs1, le premier composant étant transparent au moins au rayonnement de longueur d'onde λs1 dans une partie importante de la zone active de ce premier composant, zone dans laquelle est détecté le rayonnement de longueur d'onde λi1, ce détecteur étant **caractérisé en ce que** le premier composant comprend un circuit de détection (26) et un circuit de lecture (28) qui forment respectivement une matrice de pixels de détection et une matrice de pixels de lecture à n1 lignes et m1 colonnes, le deuxième composant comprend un circuit de détection (30) et un circuit de lecture (32) qui forment respectivement une matrice de pixels de détection et une matrice de pixels de lecture à n2 lignes et m2 colonnes, n1, m1, n2 et m2 étant des nombres entiers supérieurs ou égaux à 1, les pixels de détection et de lecture d'au moins une partie de l'un des premier et deuxième composants étant respectivement placés en regard des pixels de détection et de lecture de l'autre de ces premier et deuxième composants.

2. Détecteur selon la revendication 1, dans lequel le premier composant (22a) est apte à détecter en outre un autre rayonnement de longueur d'onde λi2 inférieure à la longueur d'onde de chaque rayonnement que le deuxième composant (24, 24a) est apte à détecter.

3. Détecteur selon l'une quelconque des revendications 1 et 2, dans lequel le deuxième composant (24a) est apte à détecter en outre un autre rayonnement de longueur d'onde λs2 supérieure à la longueur d'onde de chaque rayonnement que le premier composant (22, 22a) est apte à détecter.

4. Détecteur selon l'une quelconque des revendications 1 à 3, dans lequel le circuit de détection (26, 30) de l'un au moins des premier et deuxième composants est hybridé au circuit de lecture (28, 32) de celui-ci.

5. Détecteur selon la revendication 4, dans lequel ces circuits sont hybridés l'un à l'autre au moyen de microbilles électriquement conductrices (46).

6. Détecteur selon l'une quelconque des revendications 1 à 4, dans lequel le circuit de détection (26, 30) de l'un au moins des premier et deuxième composants est intégré monolithiquement au circuit de lecture (28, 32) de celui-ci.

7. Détecteur selon l'une quelconque des revendications 1 à 6, dans lequel les premier et deuxième composants ont le même nombre de pixels, n1 étant égal à n2 et m1 étant égal à m2.

8. Détecteur selon l'une quelconque des revendications 1 à 7, dans lequel les premier et deuxième composants ont la même topologie c'est-à-dire ont le même arrangement de pixels et le même pas entre pixels.

9. Détecteur selon l'une quelconque des revendications 1 à 8, ce détecteur comprenant en outre des couches anti-reflets (69, 70, 72, 74) aptes à empêcher des réflexions de rayonnements sur des faces de ce détecteur de manière à éviter des pertes de rayonnements.

10. Détecteur selon l'une quelconque des revendications 1 à 9, ce détecteur comprenant en outre des moyens (76) de filtrage ou d'absorption des rayonnements de longueurs d'onde inférieures ou égales à chaque longueur d'onde que le second composant est apte à détecter.

11. Détecteur selon l'une quelconque des revendications 1 à 10, dans lequel chaque circuit de lecture (28, 32) est à base de silicium.

12. Détecteur selon l'une quelconque des revendications 1 à 11, dans lequel chaque rayonnement est un rayonnement infrarouge.

## Claims

1. Multicolor radiation detector, this detector being capable of detecting at least two incident radiation with two distinct wave lengths λi1 and λs1 respectively, where λs1 > λi1, this detector comprising :
- a first component (22, 22a) capable of detecting at least the radiation with wave length λi1, and
- a second component (24, 24a) capable of detecting at least the radiation with wave length λs1,
the first component being placed facing incident radiation such that this first component receives the radiation of wave length λi1 before the second component receives the radiation of wave length λs1, the first component being transparent at least to the radiation of wave length λs1 in a large part of active area of this first component, in which the radiation of the wave length λi1 is detected, this detector being **characterized in that** the first component comprises a detection circuit (26) and a reading circuit (28) that respectively form a matrix of detection pixels and a matrix of reading pixels of n1 rows and m1 columns, the second component comprises a detection circuit (30) and a reading circuit (32) that respectively form a matrix of detection pixels and a matrix of reading pixels with n2 rows and m2 columns, where n1, m1, n2 and m2 are whole numbers equal to or greater than 1, the detection and reading pixels in at least part of one of the first and second components being placed facing the detection and reading pixels of the other of these first and second components, respectively.

2. Detector according to claim 1, in which the first component (22a) is also capable of detecting another radiation of wave length λi2 shorter than the wave length of each radiation that the second component (24, 24a) is capable of detecting.

3. Detector according to any of claims 1 and 2, in which the second component (24a) is also capable of detecting another radiation with wave length λs2 longer than the wave length of each radiation that the first component (22, 22a) is capable of detecting.

4. Detector according to any of claims 1 to 3, in which the detection circuit (26, 30) of at least one of the first and second components is hybridized to its reading circuit (28, 32).

5. Detector according to claim 4, in which these circuits are hybridized to each other by means of electrically conducting micro-balls (46).

6. Detector according to any of claims 1 to 4, in which the detection circuit (26, 30) in at least one of the first and second components is monolithically integrated to the reading circuit thereof (28, 32).

7. Detector according to any of claims 1 to 6, in which the first and second components have the same number of pixels, where n1 is equal to n2 and m1 is equal to m2.

8. Detector according to any of claims 1 to 7, in which the first and second components have the same topology in other words the same arrangement of pixels and the same pitch between pixels.

9. Detector according to any of claims 1 to 8, this detector also comprising anti-reflection layers (69, 70, 72, 74) capable of preventing reflections of radiation on surfaces of this detector to avoid radiation losses.

10. Detector according to any of claims 1 to 9, this detector also comprising means (76) of filtering or absorbing radiation with wave lengths less than or equal to each wave length that the second component is capable of detecting.

11. Detector according to any of claims 1 to 10, in which each reading circuit (28, 32) is based on silicon.

12. Detector according to any of claims 1 to 11, in which each radiation is an infrared radiation.

## Patentansprüche

1. Mehrfarben-Strahlungsdetektor, wobei dieser Detektor in der Lage ist, mindestens zwei Einfallsstrahlungen zu erkennen, die jeweils zwei verschiedene Wellenlängen λi1 und λs1 aufweisen, wobei λs1 > λi1 und dieser Detektor umfasst:
- eine erste Komponente (22, 22a), die in der Lage ist, mindestens die Strahlung der Wellenlänge λi1 zu erkennen, und
- eine zweite Komponente (24, 24a), die in der Lage ist, mindestens die Strahlung der Wellenlänge λs1 zu erkennen,
wobei die erste Komponente den Einfallsstrahlungen derart gegenüberliegt, dass diese erste Komponente die Strahlung der Wellenlänge λi1 empfängt, bevor die zweite Komponente die Strahlung der Wellenlänge λs1 empfängt,
wobei die erste Komponente in einem großen Teil der aktiven Zone dieser ersten Komponente, der Zone, in welcher die Strahlung der Wellenlänge λi1 erkannt wird, mindestens der Strahlung der Wellenlänge λs1 gegenüber durchlässig ist, wobei dieser Detektor **dadurch gekennzeichnet ist, dass** die erste Komponente eine Detektorschaltung (26) und eine Leseschaltung (28) umfasst, die jeweils eine Erkennungspixelmatrix und eine Lesepixelmatrix mit n1 Zeilen und m1 Spalten formen, die zweite Komponente eine Detektorschaltung (30) und eine Leseschaltung (32) umfasst, die jeweils eine Erkennungspixelmatrix und eine Lesepixelmatrix mit n2 Zeilen und m2 Spalten formen, wobei n1, m1, n2 und m2 Ganzzahlen größer oder gleich 1 sind und die Erkennungs- und Lesepixel mindestens eines Abschnitts einer der ersten und zweiten Komponenten jeweils den Erkennung- und Lesepixeln der anderen dieser ersten und zweiten Komponente gegenüberstehen.

2. Detektor nach Anspruch 1, wobei die erste Komponente (22a) in der Lage ist, außerdem eine andere Strahlung der Wellenlänge λi2 zu erkennen, die kleiner als die Wellenlänge jeder Strahlung ist, die von der zweiten Komponente (24, 24a) erkannt werden kann.

3. Detektor nach einem der Ansprüche 1 und 2, wobei die zweite Komponente (24a) in der Lage ist, außerdem eine andere Strahlung der Wellenlänge λs2 zu erkennen, die größer als die Wellenlänge jeder Strahlung ist, die von der ersten Komponente (22, 22a) erkannt werden kann.

4. Detektor nach einem der Ansprüche 1 bis 3, wobei die Erkennungsschaltung (26, 30) mindestens einer der ersten und zweiten Komponenten mit deren Leseschaltung (28, 32) hybridisiert ist.

5. Detektor nach Anspruch 4, wobei diese Schaltungen durch elektrisch leitende Mikrokugeln (46) miteinander hybridisiert sind.

6. Detektor nach einem der Ansprüche 1 bis 4, wobei die Erkennungsschaltung (26, 30) mindestens einer der ersten und zweiten Komponenten monolithisch mit deren Leseschaltung (28, 32) integriert ist.

7. Detektor nach einem der Ansprüche 1 bis 6, wobei die erste und zweite Komponente dieselbe Pixelzahl haben, wobei n1 gleich n2 ist und m1 gleich m2 ist.

8. Detektor nach einem der Ansprüche 1 bis 7, wobei die erste und zweite Komponente dieselbe Topologie haben, das heißt, dieselbe Pixelanordnung und denselben Pixelabstand.

9. Detektor nach einem der Ansprüche 1 bis 8, wobei dieser Detektor außerdem Antireflexschichten (69, 70, 72, 74) umfasst, die in der Lage sind, Strahlungsreflexionen auf den Flächen dieses Detektors zu verhindern, um Strahlungsverluste zu vermeiden.

10. Detektor nach einem der Ansprüche 1 bis 9, wobei dieser Detektor außerdem Mittel (76) zur Filterung oder Absorption von Strählungen umfasst, deren Wellenlängen kleiner oder gleich jeder Wellenlänge sind, die von der zweiten Komponente erkannt werden können.

11. Detektor nach einem der Ansprüche 1 bis 10, wobei jede Leseschaltung (28, 32) auf Siliziumbasis ist.

12. Detektor nach einem der Ansprüche 1 bis 11, wobei jede Strahlung eine Infrarotstrahlung ist.
